Europäisches Patentamt

European Patent Office

Office européen des brevets

(11) Publication number: 0 380 342
A2

(12) # EUROPEAN PATENT APPLICATION

(21) Application number: 90300798.7

(51) Int. Cl.5: G01R 1/067

(22) Date of filing: 25.01.90

(30) Priority: 27.01.89 GB 8901817

(43) Date of publication of application:
01.08.90 Bulletin 90/31

(84) Designated Contracting States:
DE ES FR GB IT NL

(71) Applicant: STAG MICROSYSTEMS LTD.
Martinfield
Welwyn Garden City, Hertfordshire AL7
1JT(GB)

(72) Inventor: Gilbert, Ian David
25 Carlisle Avenue
St. Albans, Herts.(GB)
Inventor: Piggott, Bruce Reginald
135 Daniells
Welwyn Garden, Herts.(GB)
Inventor: Humphreys, Chris
62 Dudley Road
Walton-on-Thames, Surrey(GB)

(74) Representative: Hale, Peter et al
Kilburn & Strode 30 John Street
London WC1N 2DD(GB)

(54) Electrical contact.

(57) An electrical contact comprises a printed circuit layout defining the contact elements on a flexible membrane (6). The membrane is attached to a resilient foam backing (10). The backing urges the contacts into engagement with the terminals of a component to which connection is to be made and also accommodates for differences in the location of the terminals from one component to another. The invention provides reliable electrical connection both in temporary (i.e. programmed test) situations and more permanent applications.

FIG . 1

EP 0 380 342 A2

# ELECTRICAL CONTACT

This invention relates to electrical contacts.

Electrical contacts must be able to provide a good electrical connection between two electrical components on a reliable basis if they are to be acceptable both as temporary contacts in, for example, test programming or diagnostic situations. The same applies equally to permanent contacts made in mass production situations in which a bad contact might lead to the manufactured article failing quality tests or being returned after sale.

Regarding temporary contacts, typically multiple probe assemblies have been used as part of test programming or diagnostic apparatus for electronic device package having multiple terminals. A multiple probe assembly may comprise a plurality of individual probes, each consisting of a spring, possibly cantilevered or S-shaped, of sufficiently resilient metal contact. The contacts are arranged to flex slightly as they establish electrical connection with the terminals of a device under test.

The contacts of such probe assemblies are designed to accommodate any variation in their spacing from neighbouring contacts and slight variation in the location of terminals when they are meant to engage. Thus, the required bulk of each contact results in typical multiple probe assemblies being large and complicated to manufacture. To a greater or lesser extent both of these factors have made good connectors expensive to develop and manufacture for electronic device packages.

In addition, a complete connection from a terminal on a device to a testing or diagnostic instrument cannot be made by a single uninterrupted electrically conductive path. There is at least the contact itself, a connection between the contact and a convenient location on the connector and a lead from there to the test/diagnostic apparatus. As the accuracy and speed of measurement improve, the problems associated with electrical noise and conductor characteristics become more acute. Furthermore, connectors with long track lengths have more resistance, capacitance and inductance which may tend to distort a test signal.

A particularly good connector arrangement for use in testing electronic components is the so-called Kelvin contact. This is basically a double contact connected to each pin terminal of the device under test.

The first way a Kelvin contact can be used is to pass a current through the corresponding component pin via the contacts. This test is carried on on all pins to check that they are individually well connected before any component test procedure is carried out.

The second way the Kelvin contact can be used is in the very accurate measurement of voltage and current required while the component is under test. As the contacts have some resistance absolute measurement from the device under test are not possible. The Kelvin contact is, therefore, used to overcome this by using the second contact as a means of adjusting the current or voltage applied to the first contact to yield the absolute levels required on the pin in question. This type of testing is referred to as the zero impedance technique and significantly reduces the distorting effect of connector length.

Kelvin contacts have not been used in surface mount device (SMD) integrated circuit technology. The requisite multiple probe assemblies for eg. plastic leadless chip carriers (PLCC) have a contact density which would require cantilever Kelvin contacts which would be both small and fragile and tend to slip off the pins of the device under test.

According to the present invention there is provided an electrical contact comprising at least one flexible electrically conductive element mounted on a cushioning substrate.

The cushioning substrate may, for example, be a foam pad or backing or an elastomeric member.

The electrically conductive element may be a printed circuit element etched on a flexible plastics backing, for example, polyimide.

It is an object of the present invention to provide a simple and reliable form of connector which is particularly, although not exclusively, useful in making temporary connection to the terminals of an electronic device package during test programming and diagnosis routines. The connector is also useful in establishing electrical connection reliably in mass production situations or other more permanent connections.

The present invention can be put into practice in various ways, some of which will now be described by way of example with reference to the accompanying drawings in which:

Figure 1 is a cross-section through part of a first embodiment of the invention;

Figure 2 is an exploded view of the embodiment in Figure 1;

Figure 3 is an exploded view of a second embodiment of the invention;

Figure 4 is a cross-section through a third embodiment of the invention; and

Figure 5 is a cross-section through a fourth embodiment of the invention.

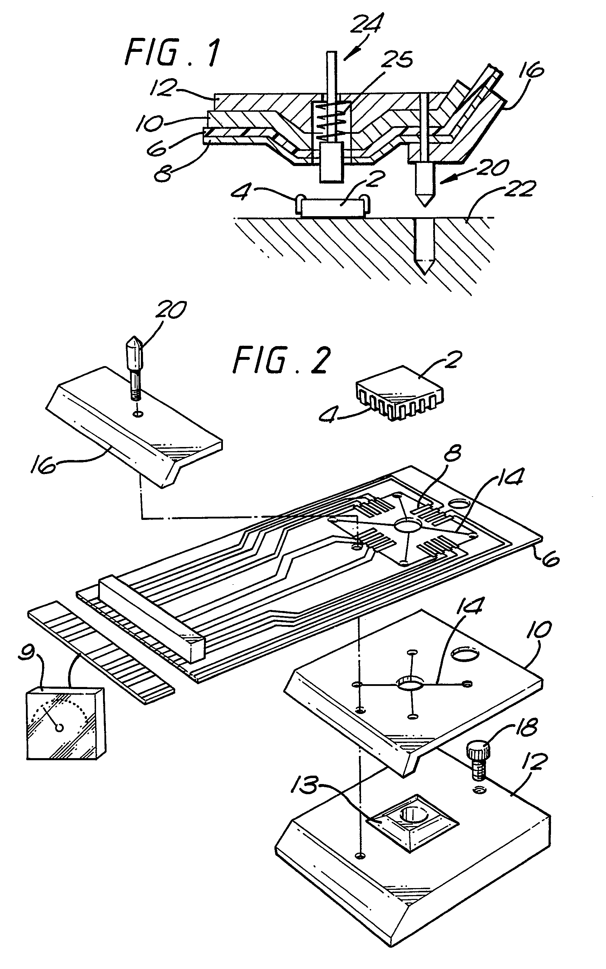

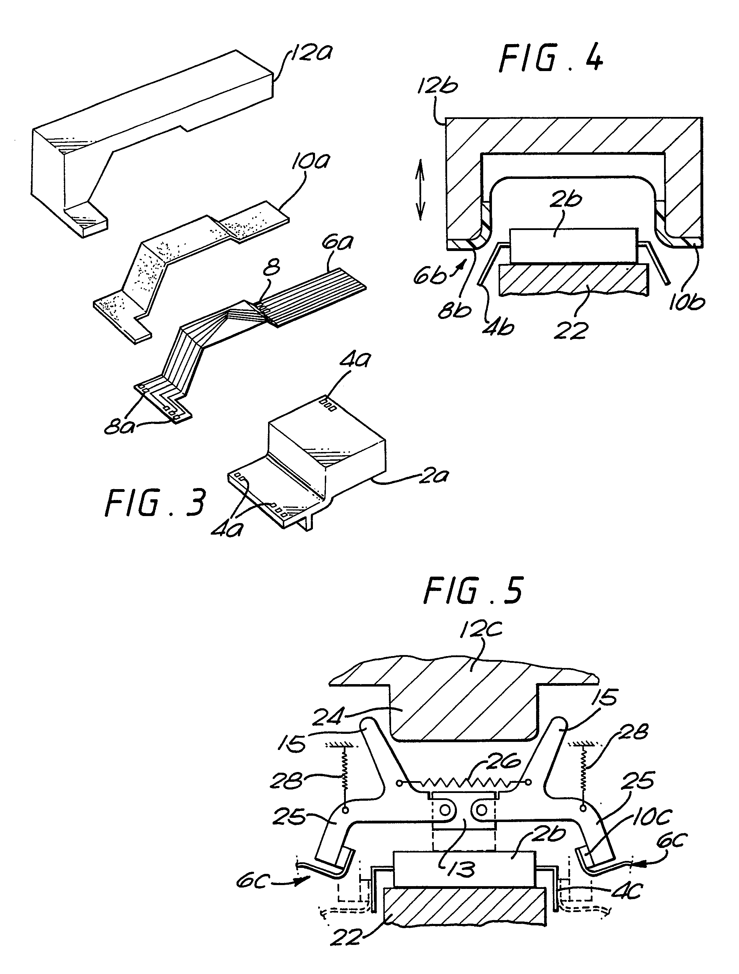

Referring to Figures 1 and 2, a first embodiment of the present invention is illustrated. This relates to an apparatus for testing an electronic multi-pin SMC device package 2 having a number of terminals or pins 4. The apparatus comprises a flexible printed circuit 6 having a plurality of contacts 8 etched on a flexible plastics backing. Each contact 8 respectively couples one of the pins 4 to a contact of test programming or diagnostic apparatus 9. The flexible printed circuit 8 is attached to a compliant backing or cushion 10, such as a resilient foam pad, which in turn is attached to a flat surface formed on a rigid support 12. The rigid support 12 is provided with a central raised land 13 which projects the contact areas out of the plane of the rest of the printed circuit 6. The backing 10 and flexible printed circuit 6 are each provided with slits 14 for enabling the compliant backing 10 and printed circuit 6 to follow the contour of the central raised portion 13 when the apparatus is assembled. A generally L-section clamp 16 is secured to the support 12 by means of a alignment pin 20. The clamp 16 serves to hold the flexible printed circuit 6 in place and also to lend it away from the contact area of the device 2. On assembly the flexible printed circuit 6 and compliant backing 10 are also held in place on the rigid support 12 by means of a machine screw 18.

The alignment pin 20 engages a support 22 for the device 2 for providing accurate positioning of the electrically conductive contacts with respect to the device 2 under test. A central rubber pad 24 is slidably mounted on a post extending through the support 12. The slidable movement of the pad 24 is biased to a projecting position by means of a spring 25 received in a recess in the support 12 behind the pad 24.

The assembly is hingedly mounted with respect to the support 22 and can be lowered onto the device 2. In so doing the projecting rubber pad 24 first engages the device 2 and holds it in place before the contacts 8 engage the corresponding pins on the device 2. The assembly descends in the correct position as dictated by the alignment pin 20.

By maintaining a slight force on the assembly, the flexible contacts 8 are depressed, against the force of the resilient backing 10, when engaging the pins of the device 2. In this way any variation in the level to which the pins project can be accommodated and the likelihood of a good connection increased.

The rubber pad 24 provides improved contact reliability by preventing the component moving as the contact assembly is lowered. Furthermore the contacts 8 made on the flexible printed circuit 6 are raised therefrom to reduce interference between the the clamp 16 and the means 22 which hold the device 2.

This embodiment of the present invention also enables the dual Kelvin contacts to be realised by arranging two half width contacts 8 with a small gap between them on the flexible printed circuit 6. The Kelvin contacts are not individually cantilevered or sprung as in the prior art and are therefore much more readily realised. In addition, as the conductor from the contact to the input of the test device can be made as a continuous ribbon of flexible metal this embodiment of the present invention enables the number of connections and physical components to be reduced. The direct connection between the ribbon and the contact can also be used to reduce the overall track length. Both of these features significantly reduce the amount of noise pick-up which can provide very significant advantages in sensitive apparatus. Also the apparatus is more compact and reliable and is cheaper to manufacture than hitherto known assemblies.

The second embodiment shown in Figure 3 may be used for programming or testing any one or more multiplane asymmetric devices as determined by the design of the flexible printed circuit 6a, the contacts 8a and the test arm or support 12a. This embodiment, although not exclusively, is particularly suitable when testing a component 2a, such as a high temperature plastics moulding, which has an integrally formed printed circuit and contacts. The complete device circuitry is printed directly onto the plastics moulding 2a thus obviating the need for a separate printed circuit. Clearly, the flexible printed circuit 6a and arm 12a must be designed as a dedicated item for testing a particular component. However, the cost effectiveness of this increases with the size of the component production run.

The contact reliability is enhanced by providing the printed circuit with the resilient backing 10a. Thus, as the former 12a closes to establish electrical connection the backing 10a urges the contacts 8a into electrical contact with the terminals 4a.

The third embodiment shown in Figure 4, is an extended wiping contact apparatus and requires a device under test, namely a dual-in-line (DIL) device 2b to be more securely restrained by a support 22. This arrangement comprises a printed circuit 6b having on it a suitably routed set of electrically conductive elements 8b which contact the pins 4b of the device. The printed circuit 6b is mounted in a cover 12b providing the rigid backing which is hinged with respect to the support 22. The inner edges of the sides of the cover 12b are provided with a resilient backing 10b adjacent the contacts 8b. Thus as the cover is closed, the contacts 8b are maintained in engagement with the pins 4b by means of the resilient backing 10b. Slight differences in the attitude of the pins 48 are accommodated by the cushioning provided by the backing 10b. Thus, the reliability of a complete set of good connections is increased over rigid contacts.

A fourth embodiment of the present invention is shown in Figure 5 which is a clamp-then-contact assembly. A cover 12c which is similar to that 12b in Figure 4 is provided with a central projection 24. A pair of jaws 25 are hingedly mounted on a central block 13 which is itself hinged about the same axis as the cover 12c.

The jaws 25 are maintained in an open position by a spring 26 attached to a cantilever 15 on each jaw, and by a pair of relatively weaker springs 28 each attached to the cover 12c and a respective jaw 25. The clamping ends of the jaws are provided with resilient backing pads 10c. As the cover and block assembly is lowered towards the device package 2b mounted on the support 22 the central block 13 engages and holds the package in place. The edges of the central projection 24 on the cover 12c engage the cam levers 15 and urge the jaws inwardly against the force of the spring 26. Eventually, the jaws force the contacts on the printed circuit 6c against the pins 4c of the device package. As before the resilience of the backing pad 10c and the flexibility of the contacts will accommodate some discrepancy in the line of the pins.

This description has been given by way of example only, and a person skilled in the art will appreciate that modifications may be made without departing from the scope of the present invention. One such modification involves omitting from the rigid support 12 the raised central portion 13 and/or the clamp 16 to provide a plane surface having the contacts 8 disposed thereon.

The invention provides a resilient contact which is simple to produce as it relies on the backing to provide the resilience and not the contact itself. The design of the contact can thus be based on considerations such as layout, contact density and contact path without having to take account to any great extent of inherent resilience. This can considerably simplify the design itself where necessary and lead to more straightforward manufacture as the contacts are etched or otherwise created and simply attached to the backing during assembly.

Furthermore, while the invention has been described in relation to temporary test contacts, it will be appreciated that the flexible contacts having a resilient backing also find considerable application in assembling components for more permanent connection. The reliability of the contacts achieved when they are held in place by a clamp or possibly a moulded encapsulation will tend to result in smaller numbers of bad electrical connections.

## Claims

1. An electrical contact comprising at least one flexible electrically conductive element (8,8a,8b) mounted on a cushioning substrate (10,10a,10b).

2. A contact as claimed in claim 1 in which the element is attached to a flexible membrane interposed between the element and the substrate.

3. A contact as claimed in claim 1 or 2 in which the element is a printed circuit on the flexible membrane.

4. A contact as claimed in claim 1, 2 or 3 in which the resilient substrate is mounted on a rigid base (12, 12a, 12b).

5. A contact as claimed in any of claims 1 to 4 in which the substrate is a foam pad.

6. An electrical connector comprising at least one contact as claimed in claim 3, means for holding a terminal to which respective connection of the or each element is to be made in a correct orientation and means for maintaining the element(s) in electrical connection with the terminals.

7. A connector as claimed in claim 6 in which the holding means are arranged to hold an electronic device, having a plurality of terminals for connection.

8. A connector as claimed in claim 6 or 7 in which the substrate is formed with a projecting land in the region of connection between the or each contact and terminal.

9. A connector as claimed in claim 6, 7 or 8 in which the substrate is hingedly mounted on an arm arranged to guide the or each contact towards its respective terminal.

10. A connector as claimed in any of claims 6 to 9 including a guide pin fixed relative to one of the substrate and holding means which is receivable within a complementary recess on the other of the substrate and holding means.

*FIG . 1*

*FIG . 2*

FIG . 4

FIG . 3

FIG . 5